# EUROPEAN PATENT SPECIFICATION

(11) **EP 4 450 454 B1**
(45) Date of publication and mention of the grant of the patent: **31.12.2025**
(21) Application number: 23168256.8
(22) Date of filing: 17.04.2023
(51) Int. Cl.: B81B 7/00, H05K 7/20

(54) **MEMS COMPONENT WITH TEMPERATURE EQUALIZER**
MEMS-BAUELEMENT MIT TEMPERATURENTZERRER
COMPOSANT MEMS AVEC ÉGALISEUR DE TEMPÉRATURE

(43) Date of publication of application: 23.10.2024
(73) Proprietor: Murata Manufacturing Co., Ltd., Nagaokakyo-shi, Kyoto 617-8555 (JP)
(72) Inventor: NURMI, Sami, 04320 Tuusula (FI); YLÄNEN, Joanna, 01620 Vantaa (FI); HURME, Susanna, 01690 Vantaa (FI); HALL, Michael, 01620 Vantaa (FI); SYRJÄNEN, Teppo, 00400 Helsinki (FI); BLOMQVIST, Anssi, 00980 Helsinki (FI); RYTKÖNEN, Ville-Pekka, 01820 Klaukkala (FI)
(74) Representative: Boco IP Oy Ab

(56) References cited:
- CN-A- 109 292 727
- JP-A- 2017 028 360

## Description

### FIELD OF THE DISCLOSURE

The present disclosure relates to microelectromechanical (MEMS) components, and more particularly to MEMS components enclosed in a ceramic package. The present disclosure further concerns the operation of such components under temperature variations.

### BACKGROUND OF THE DISCLOSURE

MEMS components such as accelerometers and gyroscopes typically comprise a MEMS chip and a package which forms a protective enclosure around the chip. The MEMS chip typically comprises a sealed cavity where the mobile parts of the chip are located. It also comprises electrical chip-level connections which extend from the mobile parts to the outside of the chip. Component-level electrical connections can be drawn from the inside of the package to the outside. When the component is mounted on a circuit board, these component-level connections are connected to the circuit board.

A control circuit is needed to carry out the input and output functions which are needed to perform a measurement with the MEMS chip. This control circuit is for practical reasons typically implemented as an application-specific integrated circuit (ASIC) which is placed inside the package together with the MEMS chip and connected to the chip-level connections for example with wire bonds.

The operation of MEMS chips is often at least to some extent temperature-dependent. Temperature calibrations therefore have to be made, and the appropriate corrections must be programmed into the control circuit. A general challenge in MEMS components is that temperature sensing must typically implemented in the control circuit, but the MEMS chip may be located at some distance from the control circuit. The temperature measured in the control circuit may therefore not correspond accurately to the temperature of the MEMS chip.

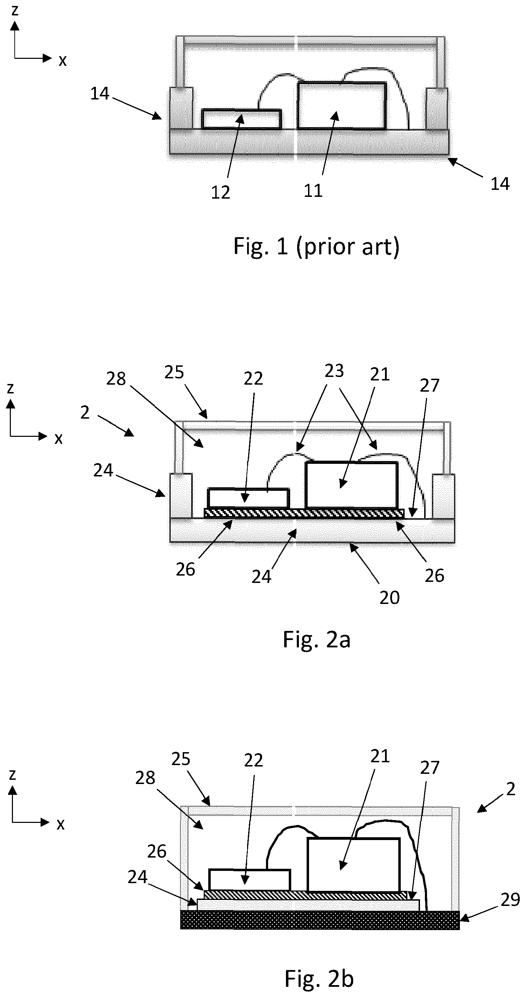

Figure 1 illustrates a component where a MEMS chip 12 and a control chip 11 are mounted in a ceramic housing 14. The temperature difference between the two chips may in some conditions be several degrees Celsius, which can lead to incorrect temperature corrections.

Document US2021210405 discloses a chip package where a first chip and a second chip are glued to a package lid with thermal glue to improve heat dissipation. However, this solution is far from optimal for MEMS applications because mechanical stress is transferred directly from the lid to the chips, which can easily degrade measurement accuracy.

Document CN109292727A discloses a two-piece MEMS gyroscope with a temperature compensation function, so that the dedicated integrated circuit chip can not only detect its own temperature, but also effectively feedback the temperature change of the MEMS device.

Document JP2017028360A discloses an arrangement for inhibiting temperature changes of an oscillation device and reducing oscillation frequency change of a vibration element which is caused by temperature characteristics of the oscillation device.

### BRIEF DESCRIPTION OF THE DISCLOSURE

An object of the present disclosure is to provide an apparatus for overcoming the above problems.

The object of the disclosure is achieved by an arrangement which is characterized by what is stated in the independent claim. The disclosure is based on the idea of implementing a heat conductor between a control chip and a MEMS chip. An advantage of this arrangement is that their temperature is equalized.

### BRIEF DESCRIPTION OF THE DRAWINGS

In the following the disclosure will be described in greater detail by means of preferred embodiments with reference to the accompanying drawings, in which
Figure 1 illustrates a MEMS component known from the prior art.
Figures 2a - 2c illustrate a MEMS component with a temperature equalizer according to the invention.

### DETAILED DESCRIPTION OF THE DISCLOSURE

This disclosure describes a MEMS component which comprises a MEMS chip, a control chip and a housing which forms an enclosure around the MEMS chip and the control chip.

The housing comprises a ceramic chip-holder which forms a mounting surface within the enclosure. The MEMS component comprises a metallic temperature equalizer on the mounting surface. The MEMS chip and the control chip are mounted on the temperature equalizer.

Figure 2a illustrates a MEMS component 2. The component comprises a MEMS chip 22 and a control chip 21. The housing of the component comprises a ceramic chip-holder 24. The term "ceramic chip-holder" refers in this disclosure to a ceramic structure which serves as a mechanical support for the chips. The chips are mounted onto the chip-holder when the component is assembled. The ceramic chip-holder may also serve as a part of the encapsulation which protects the chips from the external environment. In general, the benefit of using ceramic materials in a chip-holder is that these materials are not easily deformed by mechanical stress and have a small thermal expansion coefficient. The material of the ceramic chip-holder may for example be aluminum oxide, beryllium oxide, aluminum nitride or a mixture of these materials.

The control chip 21 may for example be an ASIC chip. The MEMS chip 22 may for example be an accelerometer chip or a gyroscope chip. Consequently, the MEMS component may be an accelerometer or a gyroscope. The control chip 21 comprises electronic circuitry for performing a measurement in the MEMS chip 22.

The MEMS chip 22 may be electrically connected to the control chip 21 with internal electrical connections 23, which may be wire bonds. These internal electrical connections may extend from chip-level connections on the MEMS chip to the control chip. The control chip may be connected with internal electrical connections 23 to component-level electrical connections which extend from the inside of the package to the outside of the package. These component-level connections have not been illustrated in figures 2a and 2b, but they may be located in the ceramic chip-holder or in other parts of the housing.

In figure 2a the chip-holder 24 is a cup, and the bottom of the cup forms the mounting surface 27. A lid 25, which may be metallic or ceramic, is on top of the cup-shaped chip-holder 24. The chip-holder 24 forms the bottom half of the housing in figure 2a, and the lid 25 forms the top half. The lid 25 and the chip-holder 24 therefore together form the housing. The inside of the housing is the enclosure 28 where the control chip 21 and the MEMS chip 22 are located. The bottom 20 of the housing define an xy-plane and a z-axis which is perpendicular to that plane. The bottom 20 may be attached to a printed circuit board (not illustrated) where an integrated circuit is assembled. The component-level electrical connections (not illustrated) may at that time also be connected to said circuit board.

The housing could alternatively have a more complex structure. Figure 2b illustrates an alternative where the ceramic chip-holder 24 is a ceramic substrate which lies on a housing bottom part 29. The lid 25 is attached to the housing bottom part 29. The housing bottom part 29 could be made of any material. The ceramic chip-holder 24 may in some embodiments have openings (not illustrated). In both figures 2a and 2b, and in all embodiments presented in this disclosure, a part of the chip-holder 24 forms a mounting surface 27.

In this disclosure the term "mounting surface" refers to a surface where both the MEMS chip 22 and the control 21 are attached. The mounting surface 27 is located inside the enclosure. The mounting surface 27 may be a flat surface, as figures 2a and 2b illustrate. The bottom surfaces of the MEMS chip 22 and the control chip 21 have the same z-coordinate in figures 2a and 2b.

Alternatively, the mounting surface may have multiple levels, and these levels may have different z-coordinates. This option has not been separately illustrated. The MEMS chip and the control chip could then be mounted on levels which have different z-coordinates. The temperature equalizer will in this case extend between these two levels.

The term "temperature equalizer" refers in this case to a structure with high thermal conductivity. The temperature equalizer may alternatively be called a heat spreader or heat distributor. The thermal conductivity of the temperature equalizer may for example be more than 5 times, more than 10 times or more than 50 times greater than the thermal conductivity of the ceramic chip-holder. The temperature equalizer may for example be made of copper, aluminium, gold, steel, nickel or tungsten. The temperature equalizer 26 may be a flat surface, as figures 2a and 2b illustrate
The temperature equalizer conducts heat from the MEMS chip 22 to the control chip 21, or vice versa, depending on which chip is warmer. If and when the temperature becomes higher in one of the chips than in the other, the temperature equalizer brings the two chips into thermal equilibrium.

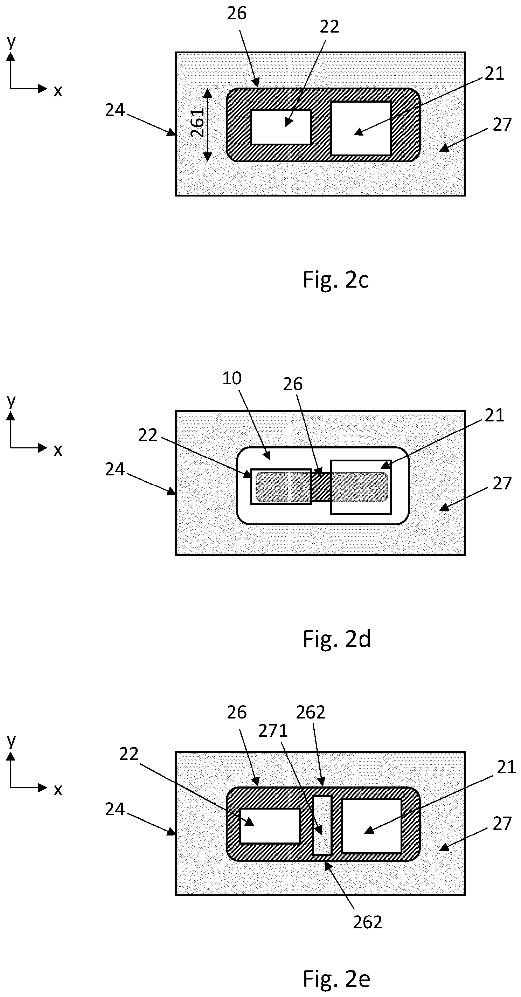

Figure 2c illustrates an xy-cross-section of the temperature equalizer 26 on the chip-mounting surface 27. The temperature equalizer 26 may extend below both the control chip 21 and the MEMS chip 22 so that the bottom surfaces of these chips lie entirely on the temperature equalizer 26. In this case the temperature equalizer covers an area below the control chip 21 and below the MEMS chip 22 which is 100% of the bottom surface of each chip.

Figure 2d illustrates an alternative where the temperature equalizer 26 is embedded in a support surface 10. This support surface 10 lies on the mounting surface 27, and its thermal conductivity is less than the thermal conductivity of the temperature equalizer 26.

In any embodiment presented in this disclosure, the temperature equalizer 26 may cover areas below the control chip 21 and below the MEMS chip 22 which are greater than 10%, greater than 25%, greater than 50% or greater than 75% of the area of the bottom surface of the respective chip.

The temperature equalizer 26 may be a uniform sheet, as in figure 2c. Here the temperature equalizer 26 has a uniform width 261 in the x-direction. In particular, the temperature equalizer here covers all of the (xy) area between the control chip 21 and the MEMS chip 22. The x-direction is here the direction in which the control chip 21 and the MEMS chip 22 are aligned with each other.

The temperature equalizer 26 may alternatively have a more complex structure or shape. Figure 2e illustrates an alternative where the temperature equalizer 26 has a central opening 271 in its xy-cross-section. The central opening 271 lies between the two chips 21 and 22. The two sides of the temperature equalizer 26 are connected to each other via narrow section 262 on each side of the opening 271. The optical geometry of the temperature equalizer 26 depends on the optimal positioning of the MEMS chip 22, the control chip 21 and additional elements of the component which may be included inside the enclosure.

Sufficient heat conductivity between the MEMS chip 22 and the control chip 21 can be ensured by giving the temperature equalizer 26 a sufficiently large surface area in its yz-cross section (using figures 2c - 2e as examples). In other words, the heat transfer rate between the two chips will be determined not only by the width of the temperature equalizer 26 in the y-direction in the (xy) area which lies between the chips, but also by its thickness in the z-direction in this area.

The metallic temperature equalizer 26 may be implemented as a heat-transfer island which is thermally isolated from the outside of the MEMS component. In other words, as the figures of this disclosure illustrate, the temperature equalizer 26 may be surrounded on all sides by materials which have a lower thermal conductivity than the temperature equalizer 26 itself. The function of the temperature equalizer, when implemented as an island, only to transfer heat between the control chip 21 and the MEMS chip 22.

Alternatively, the temperature equalizer may be implemented as a heat-transfer sink which, in addition to being intended for heat transfer between the two chips, is also intended for transferring heat away from the chips. The temperature equalizer may in this case extend from the inside of the component to the outer surface of the component, or it may be connected to the outside of the component with a channel which has high thermal conductivity. These options have not been illustrated. Either way, the part which extends to the outside of the component may be connected to a heat sink on the surface of the circuit board where the component is mounted. The control chip and the MEMS chip may in this case be actively cooled through the heat sink.

The embodiment illustrated in figure 2e can be combined with either of the embodiments illustrated in figures 2c and 2d. Any embodiment illustrated in figures 2e - 2d can be combined with either of the two embodiments illustrated in figures 2a - 2b.

## Claims

1. A MEMS component (2) which comprises
- a MEMS chip (22),
- a control chip (21),
- a housing (24, 25, 29) which forms an enclosure (28) around the MEMS chip and the control chip,
wherein the housing comprises a ceramic chip-holder (24) which forms a mounting surface (27) within the enclosure, and
the MEMS component comprises a metallic temperature equalizer (26) on the mounting surface, and the MEMS chip and the control chip are mounted on the temperature equalizer,
**characterized in that** the metallic temperature equalizer is a flat surface which extends below both the control chip and the MEMS chip so that the bottom surfaces of these chips lie entirely on the temperature equalizer.

2. A MEMS component according to claim 1, wherein the metallic temperature equalizer is implemented as a heat-transfer island which is thermally isolated from the outside of the MEMS component.

## Patentansprüche

1. MEMS-Bauelement (2), umfassend:
- einen MEMS-Chip (22),
- einen Steuerchip (21),
- ein Gehäuse (24, 25, 29), das eine Kapselung (28) um den MEMS-Chip und den Steuerchip ausbildet,
wobei das Gehäuse einen keramischen Chip-Halter (24) umfasst, der eine Montagefläche (27) in der Kapselung ausbildet, und
die MEMS-Komponente ein metallisches Temperaturausgleichselement (26) auf der Montagefläche umfasst und der MEMS-Chip und der Steuerchip auf dem Temperaturausgleichselement montiert sind,
**gekennzeichnet dadurch, dass** das metallische Temperaturausgleichselement eine flache Oberfläche ist, die sich sowohl unter dem Steuerchip als auch unter dem MEMS-Chip dergestalt erstreckt, dass die Unterseiten dieser Chips vollständig auf dem Temperaturausgleichselement aufliegen.

2. MEMS-Bauelement nach Anspruch 1, wobei das metallische Temperaturausgleichselement als Wärmeübertragungsinsel ausgeführt ist, die gegen die Außenseite des MEMS-Bauelements thermisch isoliert ist.

## Revendications

1. Composant MEMS (2) qui comprend :
- une puce MEMS (22),
- une puce de commande (21),
- un boîtier (24, 25, 29) qui forme une enveloppe (28) autour de la puce MEMS et de la puce de commande,
dans lequel le boîtier comprend un support de puce en céramique (24) qui forme une surface de montage (27) à l'intérieur de l'enveloppe, et
le composant MEMS comprend un égaliseur de température métallique (26) sur la surface de montage, et la puce MEMS et la puce de commande sont montées sur l'égaliseur de température,
**caractérisé en ce que** l'égaliseur de température métallique est une surface plate qui s'étend sous la puce de commande et la puce MEMS de telle sorte que les surfaces inférieures desdites puces reposent entièrement sur l'égaliseur de température.

2. Composant MEMS selon la revendication 1, dans lequel l'égaliseur de température métallique est réalisé en îlot de transfert thermique qui est isolé thermiquement par rapport à l'extérieur du composant MEMS.
